(19) Europäisches Patentamt
European Patent Office
Office européen des brevets

(11) **EP 4 521 407 A1**

(12) **EUROPEAN PATENT APPLICATION**

(43) Date of publication:
**12.03.2025 Bulletin 2025/11**

(21) Application number: **24161180.5**

(22) Date of filing: **04.03.2024**

(51) International Patent Classification (IPC):
**G11C 11/404** (2006.01)    **G06N 3/063** (2023.01)
**G11C 11/54** (2006.01)    **G11C 14/00** (2006.01)
**G11C 16/04** (2006.01)

(52) Cooperative Patent Classification (CPC):
**G11C 16/0466; G06N 3/063; G11C 11/404;
G11C 11/54; G11C 14/0018**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **11.09.2023 US 202318464718**

(71) Applicant: **MACRONIX INTERNATIONAL CO.,
LTD.
Hsinchu 300094 (TW)**

(72) Inventors:
• **LEE, Feng-Min**
**300 Hsinchu City (TW)**
• **TSENG, Po-Hao**
**411 Taichung City (TW)**
• **LIN, Yu-Yu**
**242 New Taipei City (TW)**
• **LEE, Ming-Hsiu**
**300 Hsinchu (TW)**

(74) Representative: **Krauns, Christian
Wallinger Ricker Schlotter Tostmann
Patent- und Rechtsanwälte Partnerschaft mbB
Zweibrückenstraße 5-7
80331 München (DE)**

(54) **UNIVERSAL MEMORIES FOR IN-MEMORY COMPUTING**

(57) A universal memory device includes an array of universal memory cells. Each universal memory cell includes a write transistor and a read transistor. The write transistor has a gate terminal configured to receive a gate voltage to turn on or off the write transistor, a first terminal configured to receive a write voltage, and a second terminal coupled to a gate terminal of the read transistor. The read transistor includes a charge trap layer at the gate terminal of the read transistor. The charge trap layer is configured to: be unalterable when the first write voltage is applied at the first terminal of the write transistor, and be alterable when the second write voltage is applied at the first terminal of the write transistor to change a threshold voltage of the read transistor. The second write voltage is greater than the first write voltage.

FIG. 4

**Description**

**TECHNICAL FIELD**

The present disclosure is directed to memories, e.g., for in-memory computing.

**BACKGROUND**

The operation of an artificial intelligence (AI) model includes a training mode and an inference mode. In the training mode, a memory with high endurance is desirable as the memory needs to be repeatedly programmed and erased to change weights. In the inference mode, a memory with high retention is desirable as the memory needs to keep weights for inference calculations.

**SUMMARY**

The present disclosure describes methods, circuits, devices, systems and techniques for providing universal memories, e.g., for in-memory computing, where a universal memory can be configured to operate in both a dynamic random-access memory (DRAM)-like mode with high endurance for AI training and a non-volatile memory (NVM)-like mode with high retention for AI inference.

One aspect of the present disclosure features a semiconductor circuit, including: a first transistor and a second transistor. The first transistor has a gate terminal configured to receive a gate voltage to turn on or off the first transistor, a first terminal configured to receive a write voltage, and a second terminal coupled to a gate terminal of the second transistor. The second transistor includes a charge trap layer at the gate terminal of the second transistor. The charge trap layer is configured to: be unalterable when a first write voltage is applied at the first terminal of the first transistor, and be alterable when a second write voltage is applied at the first terminal of the first transistor to change a threshold voltage of the second transistor, the second write voltage being greater than the first write voltage.

In some implementations, where the second write voltage is a voltage high enough to realize Fowler-Nordheim tunneling and hot carrier injection in the charge trap layer of the second transistor.

In some implementations, one of the first terminal and the second terminal is a drain terminal, and the other one of the first terminal and the second terminal is a source terminal.

In some implementations, the semiconductor circuit is configured to: operate in a first mode where a storage potential of a storage node between the second terminal of the first transistor and the gate terminal of the second transistor is determined based on the first write voltage applied at the first terminal of the first transistor while the first transistor is turned on, the threshold voltage of the second transistor remaining unchanged, the storage potential of the storage node being repeatedly changeable based on the first write voltage, and operate in a second mode where the second transistor is programmed or erased to have a particular threshold voltage based on the second write voltage applied at the first terminal of the first transistor while the first transistor is turned on, the particular threshold voltage being tunable based on the second write voltage.

In some implementations, the first mode includes a training mode of an artificial intelligence (AI) model or a dynamic random-access memory (DRAM)-like mode, and the second mode includes an inference mode of the AI model or a non-volatile memory (NVM)-like mode.

In some implementations, the storage potential of the storage node corresponds to an adjustable weight in the first mode, and the particular threshold voltage of the second transistor corresponds to a fixed weight in the second mode.

In some implementations, the particular threshold voltage of the second transistor corresponds to a binary weight "1" or "0" in the second mode.

In some implementations, the particular threshold voltage of the second transistor corresponds to an analog weight in the second mode, and the particular threshold voltage is tunable between a minimum threshold voltage and a maximum threshold voltage.

In some implementations, the second transistor is configured to be operated in a saturation region, and the storage potential of the storage node in the second mode is greater than a saturation voltage associated with the second transistor, and the second transistor is configured to receive a binary input signal at the first terminal of the second transistor, where the binary input signal represents "1" if the binary input signal has a voltage greater than a difference between the storage potential of the storage node and the minimum threshold voltage and represents "0" if the binary input signal has a voltage identical to 0 V.

In some implementations, the second transistor is configured to be operated in a triode region, and the storage potential of the storage node in the second mode is smaller than a saturation voltage associated with the second transistor, and the second transistor is configured to receive an analog input signal at the first terminal of the second transistor, where the analog input signal has a voltage in a range between 0 V and a voltage difference between the storage potential of the storage node and the maximum threshold voltage.

In some implementations, the second transistor includes a silicon-oxide-nitride-oxide-silicon (SONOS) transistor, and the first transistor includes a metal-oxide-semiconductor (MOS) transistor or an SONOS transistor.

Another aspect of the present disclosure features a semiconductor circuit, including: a first transistor and a second transistor. The first transistor has a gate terminal configured to receive a gate voltage to turn on or off the first transistor, a first terminal configured to receive a write voltage, and a second terminal coupled to a gate terminal of the second transistor. The semiconductor circuit can be configured to: operate in a first mode where a storage potential of a storage node between the second terminal of the first transistor and the gate terminal of the second transistor is determined based on a first write voltage applied at the first terminal of the first transistor while the first transistor is turned on, the threshold voltage of the second transistor remaining unchanged, the storage potential of the storage node being repeatedly changeable based on the first write voltage, and operate in a second mode where the second transistor is programmed or erased to have a particular threshold voltage based on a second write voltage applied at the first terminal of the first transistor while the first transistor is turned on, the particular threshold voltage being tunable based on the second write voltage.

Another aspect of the present disclosure features a semiconductor device including a plurality of memory cells. At least one memory cell of the plurality of memory cells includes: a write transistor and a read transistor. The write transistor has a gate terminal configured to receive a gate voltage to turn on or off the write transistor, a first terminal configured to receive a write voltage, and a second terminal coupled to a gate terminal of the read transistor. The read transistor includes a charge trap layer at the gate terminal of the read transistor, the charge trap layer being configured to: be unalterable when a first write voltage is applied at the first terminal of the write transistor, and be alterable when a second write voltage is applied at the first terminal of the write transistor to change a threshold voltage of the read transistor, the second write voltage being greater than the first write voltage.

Another aspect of the present disclosure features a semiconductor device, including: an array of memory cells; one or more write word lines (WWLs); one or more write bit lines (WBLs); one or more read word lines (RWLs); and one or more read bit lines (RBLs). Each memory cell of the array of memory cells includes: a write transistor and a read transistor. The write transistor includes a gate terminal coupled to a corresponding write word line, a first terminal coupled to a corresponding write bit line, and a second terminal coupled to a gate terminal of the read transistor, and where the read transistor includes a first terminal coupled to a corresponding read bit line and a second terminal coupled to a corresponding read word line. The read transistor includes a charge trap layer at the gate terminal of the read transistor. The charge trap layer is configured to: be unalterable when a first write voltage through the corresponding write bit line is applied at the first terminal of the write transistor, and be alterable when a second write voltage through the corresponding write bit line is applied at the first terminal of the write transistor to change a threshold voltage of the read transistor, the second write voltage being greater than the first write voltage.

In some implementations, the array of memory cells is arranged in an area defined by a first direction and a second direction perpendicular to the first direction. Each of the one or more write word lines is coupled to gate terminals of write transistors of first memory cells along the first direction, each of the one or more write bit lines is coupled to first terminals of write transistors of second memory cells along the second direction, each of the one or more read bit lines is coupled to first terminals of read transistors of third memory cells along the first direction, and each of the one or more read word lines is coupled to second terminals of read transistors of fourth memory cells along the second direction.

In some implementations, the memory cell is configured to: operate in a first mode where a storage potential of a storage node between the second terminal of the write transistor and the gate terminal of the read transistor is determined based on the first write voltage applied at the first terminal of the write transistor while the write transistor is turned on by a gate voltage applied at the gate terminal of the write transistor, the threshold voltage of the read transistor remaining unchanged, the storage potential of the storage node being repeatedly changeable based on the first write voltage, and operate in a second mode where the read transistor is programmed or erased to have a particular threshold voltage based on the second write voltage applied at the first terminal of the write transistor while the write transistor is turned on, the particular threshold voltage being tunable based on the second write voltage.

In some implementations, the first mode includes a training mode of an artificial intelligence (AI) model or a dynamic random-access memory (DRAM)-like mode, and the second mode includes an inference mode of the AI model or a non-volatile memory (NVM)-like mode.

In some implementations, the semiconductor device is configured to function as a DRAM in the first mode and to function as an NVM in the second mode.

In some implementations, the storage potential of the storage node corresponds to an adjustable weight in the training mode, and the particular threshold voltage of the read transistor corresponds to a fixed weight in the inference mode.

In some implementations, the particular threshold voltage of the read transistor corresponds to a binary weight "1" or "0" in the inference mode.

In some implementations, the particular threshold voltage of the read transistor corresponds to an analog weight in the inference mode, and the particular threshold voltage is tunable between a minimum threshold voltage and a maximum threshold voltage.

In some implementations, the analog weight is associated with a difference between the storage potential of the storage node and the particular threshold voltage.

In some implementations, the read transistor is configured to be operated in a saturation region, and the storage potential of the storage node in the inference mode is greater than a saturation voltage associated with the read transistor. The read transistor is configured to receive a binary input signal through a corresponding read bit line at the first terminal of the read transistor, where the binary input signal represents "1" if the binary input signal has a voltage greater than a difference between the storage potential of the storage node and the minimum threshold voltage and represents "0" if the binary input signal has a voltage identical to 0 V.

In some implementations, the read transistor is configured to be operated in a triode region, and the storage potential of the storage node in the inference mode is smaller than a saturation voltage associated with the read transistor. The read transistor is configured to receive an analog input signal through a corresponding read bit line at the first terminal of the read transistor, where the analog input signal has a voltage in a range between 0 V and a voltage difference between the storage potential of the storage node and the maximum threshold voltage.

In some implementations, the semiconductor device is configured to perform a multiply-accumulate (MAC) operation using the array of memory cells. The semiconductor device further includes a sense amplifier coupled to a corresponding read word line that is coupled to second terminals of read transistors of corresponding memory cells. The sense amplifier is configured to receive a sum current I from the corresponding read word line, and the sum current *I* is identical to

$$ I = \sum_i (w_i * x_i) = \sum_i (G_i * V_i), $$

where $x_i$ represents an input signal received at memory cell *i* of the corresponding memory cells, $w_i$ represents a weight of the memory cell i, $G_i$ represents a conductance of the read transistor of the memory cell *i*, and Vi represents an input voltage through a corresponding read bit line at the first terminal of the read transistor of the memory cell i.

In some implementations, the read transistor includes a silicon-oxide-nitride-oxide-silicon (SONOS) transistor. In some implementations, the write transistor includes a metal-oxide-semiconductor (MOS) transistor or an SONOS transistor.

Another aspect of the present disclosure features an operation method of a universal memory for In-Memory Computing (IMC), the operation method including: performing a training mode of an artificial intelligence (AI) model in the universal memory, where the universal memory includes at least one memory cell having a write transistor and a read transistor, where the write transistor has a gate terminal configured to receive a gate voltage to turn on or off the write transistor, a first terminal configured to receive a write voltage, and a second terminal coupled to a gate terminal of the read transistor, and where, during the training mode, a storage potential of a storage node between the second terminal of the write transistor and the gate terminal of the read transistor is determined based on a first write voltage applied at the first terminal of the write transistor while the write transistor is turned on by a gate voltage applied at the gate terminal of the write transistor, a threshold voltage of the read transistor remaining unchanged, the storage potential of the storage node being repeatedly changeable based on the first write voltage; and performing an inference mode of the AI model in the universal memory, where, in the inference mode, the read transistor is programmed or erased to have a particular threshold voltage based on a second write voltage applied at the first terminal of the write transistor while the write transistor is turned on, the particular threshold voltage being tunable based on the second write voltage.

In some implementations, the training mode includes a weight changing procedure, a weight retention procedure, and a read-operation procedure. The inference mode includes a weight changing procedure, a weight retention procedure, and a read-operation procedure.

In some implementations, the storage potential of the storage node corresponds to an adjustable weight in the training mode, and the particular threshold voltage of the read transistor corresponds to a fixed weight in the inference mode.

In some implementations, the particular threshold voltage of the read transistor corresponds to a binary weight "1" or "0" in the inference mode.

In some implementations, the particular threshold voltage of the read transistor corresponds to an analog weight in the inference mode, and the particular threshold voltage is tunable between a minimum threshold voltage and a maximum threshold voltage.

In some implementations, the analog weight is associated with a difference between the storage potential of the storage node and the particular threshold voltage.

In some implementations, performing the inference mode of the AI model in the universal memory includes:

operating the read transistor in a saturation region, where the storage potential of the storage node in the inference mode is greater than a saturation voltage associated with the read transistor; and receiving a binary input signal at the first terminal of the read transistor, where the binary input signal represents "1" if the binary input signal has a voltage greater than a difference between the storage potential of the storage node and the minimum threshold voltage and represents "0" if the binary input signal has a voltage identical to 0 V.

In some implementations, performing the inference mode of the AI model in the universal memory includes: operating the read transistor in a triode region, where the storage potential of the storage node in the inference mode is smaller than a saturation voltage associated with the read transistor; and receiving an analog input signal at the first terminal of the read transistor, where the analog input signal has a voltage in a range between 0 V and a voltage difference between the storage potential of the storage node and the maximum threshold voltage.

In some implementations, the operation method includes: performing a multiply-accumulate (MAC) operation of the AI model in the universal memory, where the MAC operation is performed in the training mode and in the inference mode, separately. Performing the MAC operation includes: generating a sum current I from a corresponding read word line coupled in serial to a set of memory cells, and the sum current I is identical to

$$ I = \sum_{i} (w_i * x_i) = \sum_{i} (G_i * V_i), $$

where $x_i$ represents an input signal received at memory cell $i$ of the set of memory cells, $w_i$ represents a weight of the memory cell $i$, $G_i$ represents a conductance of the read transistor of the memory cell $i$, and Vi represents an input voltage through a corresponding read bit line at the first terminal of the read transistor of the memory cell i.

The details of one or more disclosed implementations are set forth in the accompanying drawings and the description below. Other features, aspects, and advantages will become apparent from the description, the drawings and the claims.

## BRIEF DESCRIPTION OF THE DRAWINGS

FIGS. 1A and 1B illustrate an example of an artificial neural network (ANN) and an exploded view of a neuron of the ANN, respectively.

FIG. 2 illustrates an example memory for performing multiply-accumulate (MAC) operations.

FIG. 3A illustrates an example system for executing a training mode.

FIG. 3B illustrates an example system for executing an inference mode.

FIG. 4 illustrates an example of a universal memory cell.

FIG. 5A illustrates an example universal memory.

FIG. 5B shows realization of MAC operation using the universal memory of FIG. 5A.

FIG. 6 is a flowchart of an example process of operating a universal memory.

FIG. 7A shows a characteristic curve diagram of a write transistor in a training mode or DRAM mode.

FIG. 7B shows a characteristic curve diagram of a read transistor in a training mode or DRAM mode.

FIG. 8A shows a characteristic curve diagram of a write transistor in an inference mode or NVM mode.

FIG. 8B is a diagram showing a series of characteristic curves of a read transistor in an inference mode or NVM mode.

FIG. 9 illustrates a diagram showing a relationship between a current and a voltage on a read bit line.

FIG. 10A shows an example operation in a saturation region of a read transistor.

FIG. 10B shows an example operation in a triode region of a read transistor.

Like reference numbers and designations in the various drawings indicate like elements. It is also to be understood that the various exemplary implementations shown in the figures are merely illustrative representations and are not necessarily drawn to scale.

## DETAILED DESCRIPTION

Implementations of the present disclosure provide methods, circuits, devices, systems and techniques for providing universal memories for in-memory computing. In some implementations, a universal memory is configured to operate in both a dynamic random-access memory (DRAM)-like mode with high endurance and a non-volatile memory (NVM)-like mode with high non-volatility and high retention. That is, the universal memory can integrate functions of different types of memories including memories with high reliability (e.g., DRAM) and memories with high retention (e.g.,

NVM). The universal memory can be applied for in-memory computing (IMC) which enables massively parallel dot products while keeping one set of operands in memory. For example, the universal memory can be configured for computationally demanding artificial intelligence (AI) applications, e.g., for deep neural networks (DNNs) and recurrent neural networks (RNNs).

The universal memory can be configured to perform both AI training and AI inference, e.g., in multiply-accumulate (MAC) calculation or multiply-add (MAD) operation. All the operations can be performed in the universal memory and no data is transmitted between different memories or between computational resources (e.g., computing processing units (CPUs) or processors) and data memory, which can suppress or eliminate Von-Neumann bottleneck issue to reduce substantial latency and significantly lower energy dissipation or power consumption, improve processing speed and efficiency, and simplify a system for AI applications, thereby improving an overall performance of the system for AI applications.

In some implementations, the universal memory includes an array of memory cells. Each memory cell can be a universal memory cell configured to perform a DRAM-like operation such as training in AI computing and an NVM function such as inference in analog mode. The universal memory can have high endurance (e.g., almost unlimited endurance) to meet huge weight updates during training of big data, and can also have non-volatility and high retention to keep weights fixed with low power consumption.

The universal memory can be configured to perform a dual mode operation in two-transistor (2T) charge trap memory cells. In some implementations, the universal memory cell includes a write transistor and a read transistor. The write transistor is coupled to a write word line (WWL) and a write bit line (WBL), while the read transistor is coupled to a read word line (RWL) and a read bit line (RBL). The read transistor can be a charge trap transistor (CTT) that includes a charge trap layer having charge storage capability. In some examples, the read transistor is a silicon-oxide-nitride-oxide-silicon (SONOS) field-effect transistor (FET) where nitride layer is the charge trap layer. The write transistor can be a transistor with charge storage capability such as SONOS FET or a transistor without charge storage capability such as metal-oxide-semiconductor field-effect transistor (MOSFET).

In some implementations, under the DRAM-like mode, the write transistor is turned on by a write voltage at WWL to charge or discharge a gate node (or a storage node) of the read transistor with a write voltage at the WBL, and a logic state of the memory cell depends on how much charges are stored at the gate node of the read transistor that depends on the write voltage at the WBL to the write transistor. The storage mode of the memory cell can be a least in part similar to that of a DRAM memory cell. As the write voltage at the WBL is low, the charge trap layer is not programmed/erased. Therefore, the read transistor can have high endurance, and the memory cells operated in the DRAM-like mode can be used for in-memory-computing in AI training.

In some implementations, under the NVM mode, the Fowler-Nordheim tunneling and hot carrier injection mechanism (+FN/-FN) can be used to modify the amount of the charges in the charge trap layer of the read transistor. Thus, the read transistor can be programmed/erased (e.g., with +FN/-FN having high voltages) to have multi-level threshold voltages Vt with non-volatility capability, e.g., Vt can be tunable. The various Vt levels can be used to determine logic states of a memory cell. The memory cells operated in the NVM mode can be used in in-memory-computing for AI inference, where Vt can be used as a fixed weight. The read transistor can be operated in both triode region and saturation region. Write bit line (WBL) read voltage can be constant at a same level under the condition of a tunable Vt for read transistor.

A logic state in the universal memory cell operated in DRAM mode can be determined by storing charge in a sensing node of the memory cell for short-term memory (e.g., with retention less than 10^4 second) by low voltage operation (e.g., less than 3 V). Thus, the universal memory cell can function like DRAM memory cell. Compared to conventional DRAM memory cell having one transistor and one capacitor (1T1C) structure, the universal memory cell has two transistors and no capacitor (2T0C) structure, which may have a compacter structure, a simpler fabrication process, and be cost-efficient. The logic state can be stored by FN program/erase in the read transistor (and/or the write transistor) for NVM operation. Further, the universal memory cell can be applied to AI model training by in-memory computing (IMC) in DRAM mode, and can do inference by IMC in NVM mode with fixed weights. Vt values in the read transistor (and/or the write transistor) can serve as weights for MAC operations that can be realized in memory array of the universal memory cells by Ohmic's and Kirchoff's law.

In some implementations, the universal memory cell has analog I-V curve or characteristics in the read transistor, which enables analog operation (e.g., analog training or inference) in the universal memory cell. Analog training or inference can be more efficient than binary training or inference. In some cases, the universal memory cell is configured for operations with analog weight Vt and binary input (" 1" or "0" from a voltage $V_{RBL}$ at read bit line for the read transistor), and the read transistor is operated in a saturation region. In some cases, the universal memory cell is configured for operations with analog weight Vt and analog input $V_{RBL}$, and the read transistor is operated in a triode region.

The techniques can be applied to any suitable charge-trapping based memory devices, e.g., silicon-oxide-nitride-oxide-silicon (SONOS) memory devices. The techniques can be applied to two-dimensional (2D) memory devices or three-dimensional (3D) memory devices. The techniques can be applied to various memory types, such as SLC (single-level cell) devices, MLC (multi-level cell) devices like 2-level cell devices, TLC (triple-level cell) devices, QLC (quad-level cell) devices, or PLC (penta-level cell) devices.

The techniques can be applied to various types of storage systems, e.g., storage class memory (SCM), storage systems that are based on various types of memory devices, such as static random access memory (SRAM), dynamic random access memory (DRAM), resistive random access memory (ReRAM), magnetoresistive random-access memory (MRAM), or phase-change memory (PCM) among others. Additionally or alternatively, the techniques can be applied to systems based on, for example, NAND flash memory or NOR flash memory, such as universal flash storage (UFS), peripheral component interconnect express (PCIe) storage, embedded multimedia card (eMMC) storage, storage on dual in-line memory modules (DIMM), among others. The techniques can also be applied to magnetic disks or optical disks, among others. The techniques can be applied to any suitable applications, e.g., applications that use AI mechanisms such as ANNs for deep learning. These applications can include gaming, natural language processing, expert systems, vision systems, speech recognition, handwriting recognition, intelligent robots, data centers, cloud computing services, and automotive applications, among others.

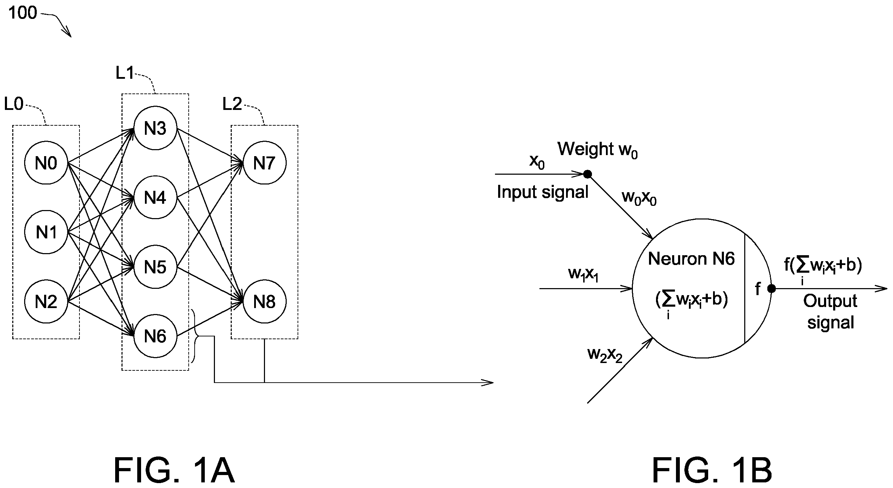

FIGS. 1A and 1B illustrate an example of an artificial neural network (ANN) 100 and an exploded view of a neuron N6 of the ANN 100, respectively. As shown in FIG. 1A, the ANN 100 is a collection of connected units or nodes, e.g., N0, N1, N2, N3, N4, N5, N6, N7 and N8, which are called artificial neurons. The artificial neurons are organized in layers. For example, layer L0 includes artificial neurons N0, N1 and N2; layer L1 includes artificial neurons N3, N4, N5 and N6; and layer L2 includes artificial neurons N7 and N8.

In some implementations, different layers of an ANN perform different kinds of transformations on their inputs. One of the layers is a first or input layer of the ANN, e.g., layer L0, while another layer is a last or output layer of the ANN, e.g., layer L2. The ANN includes one or more internal layers, e.g., layer L1, between the input layer and the output layer. Signals travel from the input layer to the output layer, after traversing the internal layers one or more times.

In some implementations, each connection between artificial neurons, e.g., a connection from N2 to N6, or from N6 to N8, can transmit a signal from one to another. The artificial neuron that receives the signal can process it and then signal artificial neurons connected to it. In some implementations, the signal at a connection between artificial neurons is a real number, and the output of each artificial neuron is calculated by a non-linear function of the sum of its inputs. Each connection can have a weight that adjusts as learning proceeds. The weight increases or decreases the strength of the signal at a connection.

In some implementations, a set of input data (e.g., from each sample) is presented to an ANN, e.g., at an input layer like L0. A series of computations is performed at each subsequent layer such as L1. In the fully-connected network illustrated in FIG. 1A, an output computation from each node is presented to all nodes in the subsequent layer. The final layer such as L2 of the trained ANN can be associated with determining a classification match to the input data, e.g., from a fixed set of labeled candidates, which can be referred to as "supervised learning."

FIG. 1B shows an exploded view of a computation performed at an artificial neuron N6, which is an example of artificial neurons in an ANN. Input signals $x_0$, $x_1$ and $x_2$ from other artificial neurons of the ANN 100, e.g., from artificial neurons N0, N1 and N2 respectively, are sent to the artificial neuron N6. Each input signal is weighted by a weight associated with the corresponding connection, and the weighted signal is received and processed by the artificial neuron. For example, the connection from artificial neuron N0 to artificial neuron N6 has a weight $w_0$ that weights the signal $x_0$ sent from N0 to N6 via the connection, such that the value of the signal received and processed by N6 is $w_0x_0$. Similarly, the connections from artificial neurons N1 and N2 to artificial neuron N6 have weights $w_1$ and $w_2$ respectively, such that the value of the signals received by N6 from N1 and N2 are $w_1x_1$ and $w_2x_2$, respectively.

An artificial neuron processes the weighted input signals internally, e.g., by changing its internal state (referred to as activation) according to the input, and produces an output signal depending on the input and the activation. For example, the artificial neuron N6 produces an output signal that is a result of output function $f$ that is applied to the weighted combination of the input signals received by the artificial neuron N6. In this manner, the artificial neurons of the ANN 100 form a weighted, directed graph that connects the outputs of some neurons to the inputs of other neurons. In some implementations, the weights, the activation function, the output function, or any combination of these parameters of an artificial neuron, can be modified by a learning process, e.g., deep learning.

In some implementations, the computation is a multiply-accumulate (MAC) calculation, which can be an action in the AI operation. As illustrated in FIG. 1B, each data value $x_i$ of a plurality of input signals is multiplied by its related weight $w_i$, then summed to obtain $\Sigma_i w_i x_i$, and a final bias value $b$ may be added to obtain a computed value $z = (\Sigma_i w_i x_i + b)$. Then, the computed value $z$ is calculated through an activation function $f$ to obtain an output value $a = f(\Sigma_i w_i x_i + b)$. The output value $a$ can be provided as a node output (or an output signal) to the next layer as an input.

An AI model, e.g., the ANN 100, can be operated in a training mode and an inference mode. For the AI model to provide an answer to a problem, the connections between the answer and the problem can be addressed by repeatedly exercising network training. In the training mode, initially the AI model is given a set of test data with correct labels, known as training data. Then, the inference of the AI model generated by the set of test data is monitored, to which the AI model can respond truthfully or falsely. The aim of the learning method is to detect patterns, and what the AI model does in this case is to search and group the data according to their similarity. The AI training mode can be similar to a training in multimedia data processing. Mathematically, in the training mode, weights in the AI model are adjusted to get a maximized output. In the inference mode, the AI model is put into practice based on what the AI model has learned in training. The AI model can create an inference model with trained and fixed weights to classify, solve, and/or answer the problem.

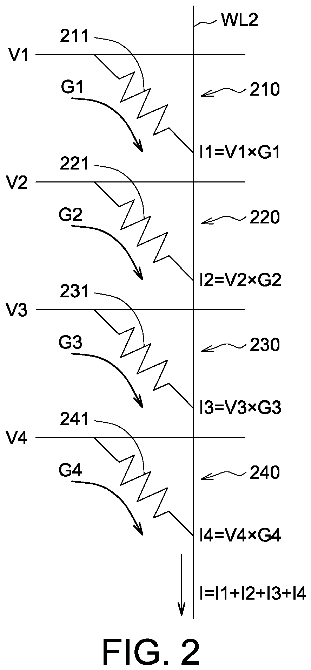

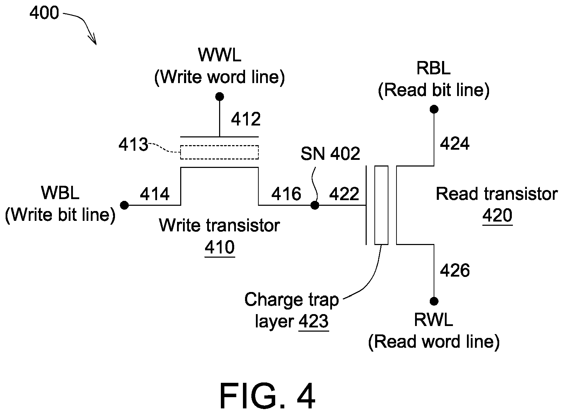

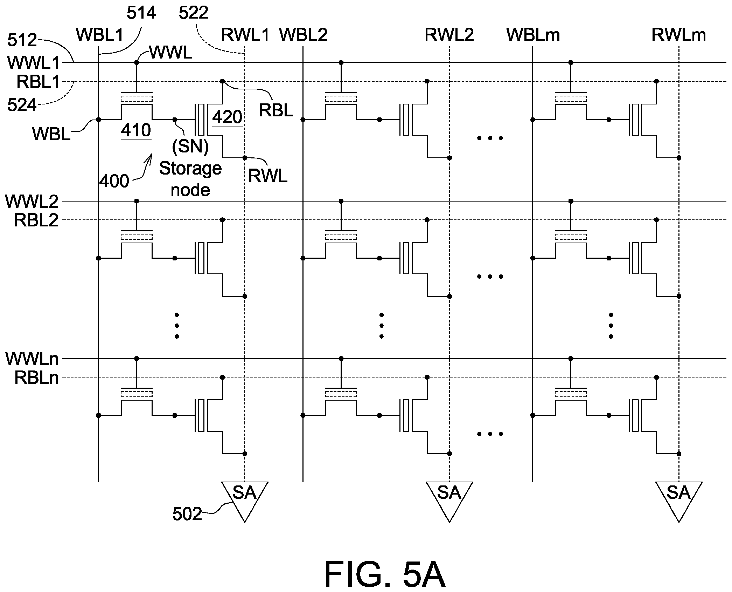

FIG. 2 shows an example memory 200 for performing a multiply-accumulate calculation (MAC). The memory 200 can be a universal memory as described in the present disclosure, e.g., the universal memory in FIGS. 5A-5B. The memory 200 includes, for example, a plurality of memory cells 210, 220, 230, 240. A memory cell can include a universal memory cell, e.g., as described with further details in FIGS. 4A-4B. The memory cells 210, 220, 230, 240 include, for example, resistors 211, 221, 231, 241 respectively. The resistors 211, 221, 231, 241 have conductances G1, G2, G3, G4, respectively.

When voltages V1, V2, V3, V4 are respectively inputted to a bit line BL2, a plurality of respective read currents I1, I2, I3, I4 flow into a word line WL2. The read current I1 is equivalent to a product of the voltage V1 and the conductance G1; the read current I2 is equivalent to a product of the voltage V2 and the conductance G2; the read current I3 is equivalent to a product of the voltage V3 and the conductance G3; the read current I4 is equivalent to a product of the voltage V4 and the conductance G4. A total current I is equivalent to a sum of products of the voltages V1, V2, V3, V4 and the conductances G1, G2, G3, G4. If the voltages V1, V2, V3, V4 represent the input signals $x_i$, and the conductances G1, G2, G3, G4 represent the weights $w_i$, then the total current I represents the sum of the products of the input signals $x_i$ and the weights $w_i$ as described in the following equation (1):

$$I = \sum_{i} (w_i * x_i) = \sum_{i} (G_i * V_i) \qquad (1)$$

Through the memory 200 in FIG. 2, an MAC in the artificial intelligence operation can be realized.

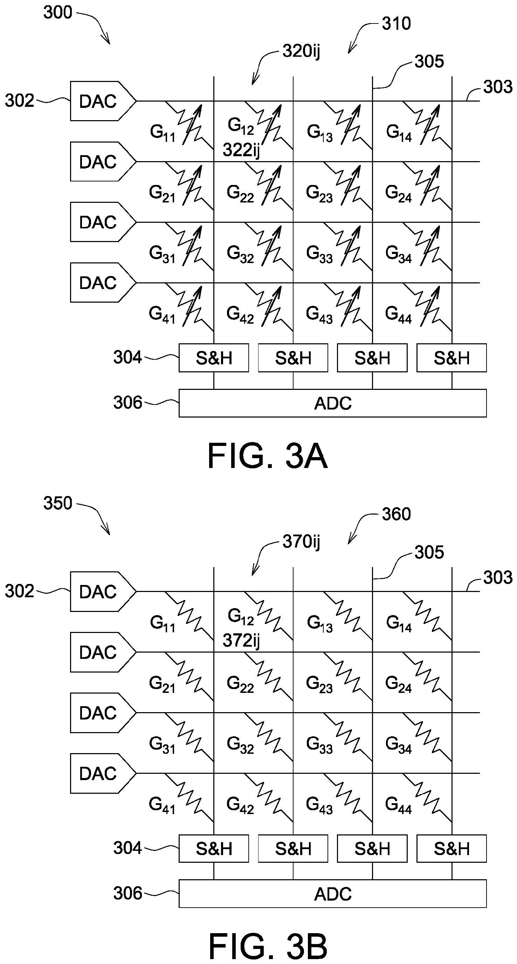

FIG. 3A illustrates an example system 300 for executing a training mode. The system 300 includes a memory 310 that includes, for example, a plurality of memory cells $320_{ij}$ arranged in a matrix. The system 300 can further include a plurality of digital to analog converter (DAC) 302 each coupled to a respective bit line 303 (e.g., the bit line BL2 of FIG. 2). Each DAC 302 is configured to convert an input digital signal, e.g., voltage such as V1, V2, V3, V4 of FIG. 2, into an analog voltage signal. The system 300 can also include a plurality of sampling & holding (SH) unit 304 each coupled to a respective word line 305 (e.g., the word line WL2 of FIG. 2) and an analog to digital converter (ADC) 306 coupled to the plurality of SH units 304. Each SH unit 304 can include one or more logic units and/or circuits configured to sample and hold a summed current analog signal (e.g., I in FIG. 2) along the respective word line 305, and the ADC 306 can be configured to sum up the summed current analog signal from each word line 305 and convert the final sum result from an analog signal into a digital signal for further processing.

Each of the memory cells $320_{ij}$ can have an adjustable resistor $322_{ij}$, for example. Each of the adjustable resistors $322_{ij}$ has a conductance $G_{ij}$, e.g., G1 211, G2 221, G3 231, or G4 241 of FIG. 2. These conductances $G_{ij}$ can be used to represent the weights $w_{ij}$, e.g., w; as illustrated in FIG. 1B. When the memory 310 executes a training mode, the weights $w_{ij}$ need to be updated continuously, so the memory 310 with the adjustable resistors $322_{ij}$ can be used to execute the training mode smoothly. Thus, it is desirable to have the memory 310 having almost unlimited endurance to meet a huge weight update during training of big data for AI training.

FIG. 3B illustrates an example system 350 for executing an inference mode. The system 350 is similar to the system 300 and includes DACs 302, S&H units 304 and ADC 306. Different from the system 300 of FIG. 3A, the system 350 includes a memory 360 that is different from the memory 310. The memory 360 includes, for example, a plurality of memory cells $370_{ij}$ arranged in a matrix. Each of the memory cells $370_{ij}$ has a fixed resistor $372_{ij}$, for example, which is different from the memory cells 320ij with an adjustable resistor $322_{ij}$. Each of the fixed resistors $322_{ij}$ has a fixed conductance $G_{ij}$. These conductances $G_{ij}$ can be used to represent fixed weights $w_{ij}$. In the process of executing the inference mode, the weights $w_{ij}$ have already been set and are not changed arbitrarily, e.g., based on trained $G_{ij}$ of FIG. 3A, so the memory 360 with the fixed resistors $372_{ij}$ can be used to execute the inference mode smoothly. Thus, it is desirable to have the memory 360 that has non-volatility and good retention to keep the weights fixed with low power consumption for AI inference.

As described above, the requirements of the training mode and the inference mode are different. For example, the memory 310 that executes the training mode needs to have high endurance to meet a large number of updating actions on the weights $w_{ij}$, and the memory 360 that executes the inference mode needs to have non-volatility and high retention, so that the weights $w_{ij}$ can be kept at low power consumption. These two types of memory are normally completely different. For example, the memory 310 in FIG. 3A and the memory 360 in FIG. 3B use completely different resistors (the adjustable resistors $322_{ij}$ and the fixed resistors $372_{ij}$).

As described with further details below, implementations of the present disclosure provide a universal memory configured to operate in both a dynamic random-access memory (DRAM)-like mode with high endurance and a non-volatile memory (NVM)-like mode with high non-volatility and high retention. That is, the universal memory can integrate functions of different types of memories including memories with high reliability and memories with high retention. The universal memory can be applied for in-memory computing (IMC). The in-memory computing can be also called as computing in-memory, in-memory processing, or processing in-memory (PIM) or processing in memory (PIM).

In some implementations, the universal memory includes a plurality of universal memory cells. As discussed with further details below, each universal memory cell can be configured to have a first parameter (e.g., a voltage at a storage node) that can be adjustable for training mode and have a second parameter (e.g., a threshold voltage of a read transistor) that can be fixed for inference mode. The second parameter can be based on the first parameter.

FIG. 4 illustrates an example of a universal memory cell 400. The universal memory cell 400 can be used for in-memory computing (IMC). In some implementations, as shown in FIG. 4, the universal memory cell 400 includes a write transistor 410 and a read transistor 420 that is coupled to the write transistor 410. Since the universal memory cell 400 is composed of two transistors, it can be also called 2T structure.

The write transistor 410 includes a gate terminal 412, a first terminal 414, and a second terminal 416. One of the first terminal 414 and the second terminal 416 is a drain terminal, and the other one of the first terminal 414 and the second terminal 416 is a source terminal. Similarly, the read transistor 420 includes a gate terminal 422, a first terminal 424, and a second terminal 426. One of the first terminal 424 and the second terminal 426 is a drain terminal, and the other one of the first terminal 424 and the second terminal 426 is a source terminal. The second terminal 416 of the write transistor 410 is coupled to the gate terminal 422 of the read transistor 420. A storage node (SN) 402 is coupled between the second terminal 416 and the gate terminal 422.

Different from a normal memory cell having one transistor coupled to a write line and a bit line, the universal memory cell 400 has two transistors coupled to two write lines and two bit lines. For example, as shown in FIG. 4, the gate terminal 412 of the write transistor 410 is coupled to a write word-line (WWL) and configured to receive a gate voltage $V_{WWL}$, and the first terminal 414 of the write transistor 410 is coupled to a write bit-line (WBL) and configured to receive a write voltage (or a read voltage) $V_{WBL}$. The first terminal 424 of the read transistor 420 is coupled to a read bit-line (RBL) and configured to receive a read voltage $V_{RBL}$, and the second terminal 426 of the read transistor 420 is coupled to a read word-line (RWL) and configured to receive a write voltage (or a read voltage) $V_{RWL}$.

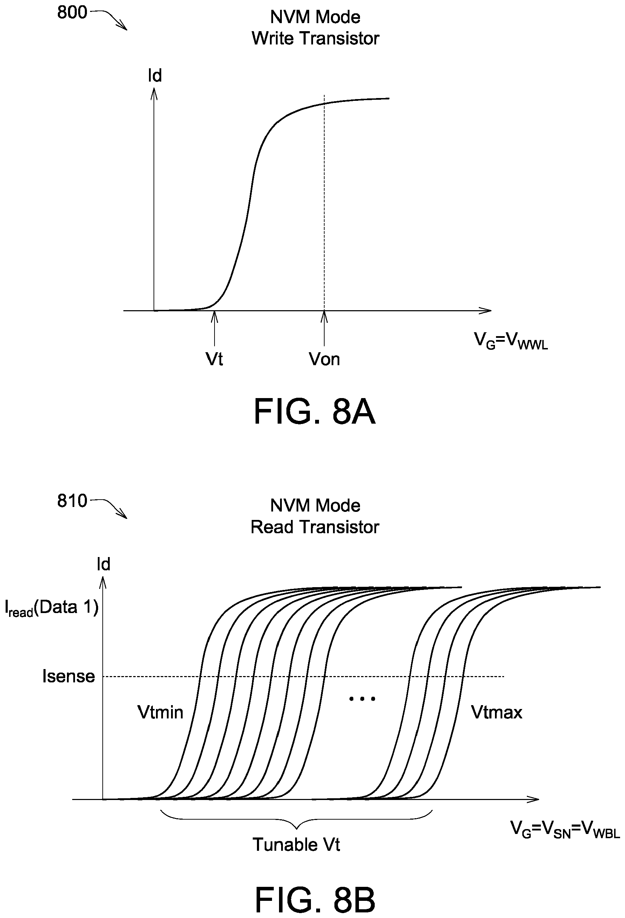

The read transistor 420 can be configured to have an adjustable threshold voltage, such that the universal memory cell 400 can be used in an inference mode to set a fixed weight each time. In some implementations, the read transistor 420 includes a charge trap layer 423 at the gate terminal 422. The charge trap layer 423 can be referred to as a charge storage layer or a charge trapping layer. According to the Fowler-Nordheim (FN) tunneling and hot carrier injection mechanism, when a high voltage (e.g., positive voltage like +FN or negative voltage like -FN) is applied at the gate terminal 422, the high voltage (e.g., +FN/-FN) can modify an amount of charges stored in the charge trap layer 423, thereby changing a threshold voltage of the read transistor 420. The threshold voltage of the read transistor 420 can be changed based on a value of the applied high voltage and a time period of applying the high voltage on the gate terminal 422. That is, the threshold voltage of the read transistor 420 can be tunable in a range from a lowest threshold voltage $V_{tmin}$ to a highest threshold voltage $V_{tmax}$ (e.g., as illustrated in FIG. 8B). As discussed below, with the charge trap layer 423, the read transistor 420 can be programmed or erased to have various Vt levels to determine corresponding logic gates and/or set various fixed weights (e.g., digital weight or analog weight).

In some implementations, the read transistor 420 includes a silicon-oxide-nitride-oxide-silicon (SONOS) field-effect transistor (FET) where nitride layer (e.g., silicon nitride SiN layer) is the charge trap layer 423. In some implementations, the write transistor 410 is a transistor without charge storage capability such as metal-oxide-semiconductor field-effect transistor (MOSFET). That is, a threshold voltage of the write transistor 410 is fixed and/or predetermined that cannot be changed. In some implementations, the write transistor 410 also includes a charge trap layer 413, e.g., as illustrated in FIG. 4, and a threshold voltage of the write transistor 410 can be adjusted based on an operation. The write transistor 410 can be also a SONOS FET transistor.

The read transistor 420 can have a low off-current to ensure good data retention. In some examples, the channel layer of the read transistor 420 includes indium gallium zinc oxide (IGZO), indium oxide ($In_2O_3$), silicon (Si), germanium (Ge), or a trivalent-pentavalent group (III-V) material. In some examples, the write transistor 410 has a high on-current to ensure reading accuracy. The channel layer of the write transistor 410 can include Indium Gallium Zinc Oxide (IGZO), Indium Oxide ($In_2O_3$), Silicon (Si), Germanium (Ge) or Trivalent-pentavalent group material.

FIG. 5A illustrates an example universal memory 500 including an array of universal memory cells 400 of FIG. 4. Each universal memory cell 400 includes a write transistor 410 and a read transistor 420 that are coupled to each other. The universal memory 500 includes one or more write word lines WWLs 512, one or more read word lines RWLs 522, one or more write bit lines WBLs 514, one or more read bit lines RBLs 524.

For each universal memory cell 400, the gate terminal 412 of the write transistor 410 is connected to a corresponding write word line WWL 512, the first terminal 414 (one of the drain terminal and the source terminal) of the write transistor 410 is connected to a corresponding write bit line WBL 514, and the second terminal 416 (the other one of the drain terminal and the source terminal) of the write transistor 410 is connected to the gate terminal 422 of the read transistor 420. The first terminal 424 (one of the drain terminal and the source terminal of the read transistor 420) is connected to a corresponding read bit line 524, and the second terminal 426 (the other one of the drain terminal and the source terminal of the read transistor 420) is connected to a read word line RWL 522.

Each write word line WWL 512 is connected to a plurality of gate terminals 412 of write transistors 410 of corresponding universal memory cells 400 along a first direction, and each write bit line WBL 514 is connected to a plurality of first terminals 414 of write transistors 410 of corresponding universal memory cells 400 along a second direction that can be perpendicular to the first direction. Similarly, each read bit line RBL 524 is connected to a plurality of first terminals 424 of read transistors 420 of corresponding universal memory cells 400 along the first direction, parallel to the write word lines 512, and each read word line RWL 522 is connected to a plurality of second terminals 426 of read transistors 420 of corresponding universal memory cells 400 along the second direction, parallel to the write bit lines 514.

In some implementations, the universal memory 500 includes a plurality of sense amplifiers (SAs) 502. Each SA 502 is coupled to a corresponding RWL 522 and configured to receive a sum of read currents from memory cells coupled to the corresponding RWL 522, e.g., as illustrated in FIG. 2.

In some implementations, the universal memory 500 is applicable to both of the training mode and the inference mode of an artificial intelligence (AI) model. When the universal memory 500 is executed in the training mode, it can provide high reliability, similar to or same as, Dynamic Random Access Memory (DRAM), so as to satisfy a large number of updating actions on weights. The universal memory 500 in the training mode can be implemented as the memory 310 of FIG. 3A. When the universal memory 500 is executed in the inference mode, the universal memory 500 can provide non-volatility and high retention, similar to or same as non-volatile memory (NVM), to enable weights to be kept well with low power consumption. The universal memory 500 in the inference mode can be implemented as the memory 360 of FIG. 3B.

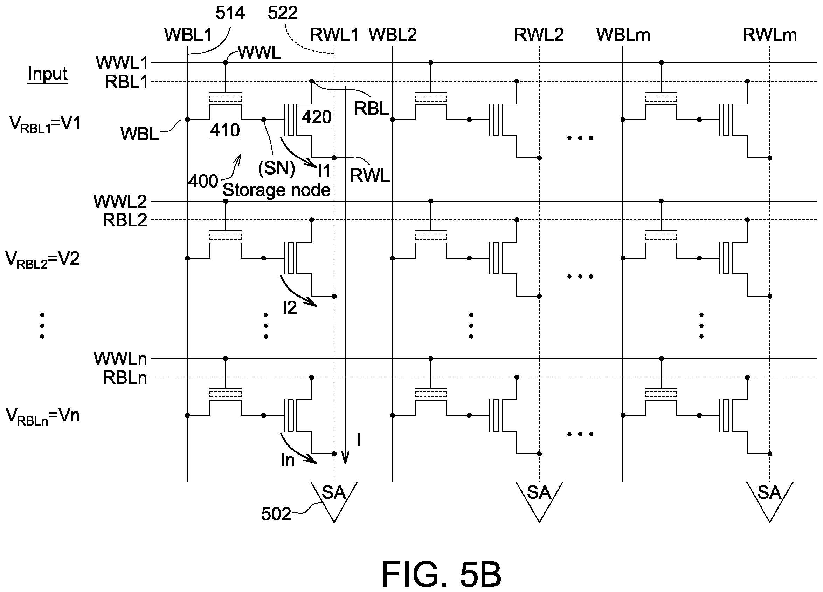

The universal memory 500 can be applied to realize one or more operations of the AI model, e.g., multiply-accumulate (MAC) operation. The MAC operation is based on Ohmic's and Kirchoff's law. FIG. 5B shows realization of the MAC operation using the universal memory 500. A series of input signal $x_i$, e.g., V1, V2, ..., Vn, are applied on the corresponding read bit lines RBL1, RBL2, ..., RBLn, respectively. The amount of the read current Ii (e.g., 0 or 1) from each universal memory cell 400 is equivalent to the product of the input signal $x_i$ and the weight $w_i$ (e.g., 0 or 1). Accordingly, for each read word line 522, a total current I received by the SA 502 can be calculated based on the above equation (1):

$$I = \sum_{i=1}^{n}(w_i \cdot x_i) = \sum_{i=1}^{n}(G_i \cdot V_i)$$

, where Gi represents conductance of the read transistor 420, corresponding to the weight $w_i$.

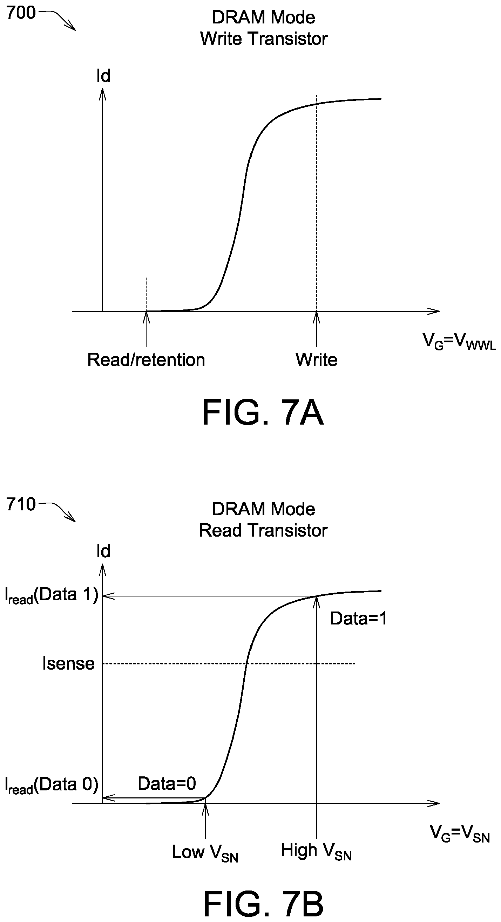

As discussed below, the weight $w_i$ of the universal memory cell 400 can be digital or binary weight, e.g., "1" or "0". In some cases, the weight $w_i$ is represented by a storage potential $V_{SN}$ at the storage node SN 402 between the write transistor 410 and the read transistor 420, e.g., in a training mode or DRAM mode as described in FIGS. 7A-7B. In some cases, the weight $w_i$ of the universal memory cell 400 can be represented by a threshold voltage of the read transistor 420, e.g., in an inference mode or NVM mode as described in FIGS. 8A-8B.

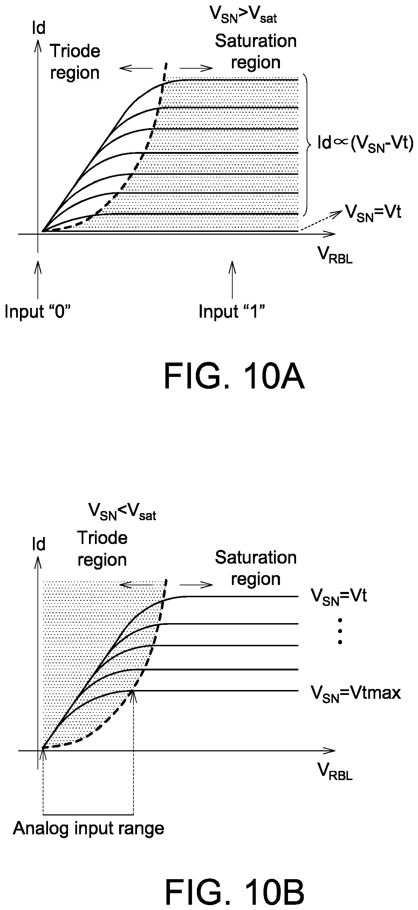

The weight $w_i$ of the universal memory cell 400 can be analog weight, e.g., represented by an adjustable threshold voltage of the read transistor 420, e.g., in an inference mode or NVM mode as described in FIGS. 10A-10B. In some cases, the universal memory cell 400 can be operated with analog weight and binary (1 or 0) input signals, e.g., in the saturation region as illustrated in FIG. 10A. In some cases, the universal memory cell 400 can be operated with analog weight and analog input signals, e.g., in the triode region as illustrated in FIG. 10B.

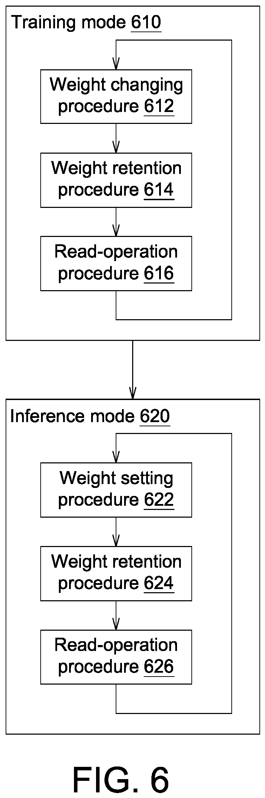

FIG. 6 is a flowchart of an example process 600 of operating a universal memory, e.g., for training and inference of an artificial intelligence (AI) model. The universal memory can be the universal memory 500 of FIGS. 5A-5B. The universal memory includes an array of universal memory cells (e.g., the universal memory cells 400 of FIG. 4). Each universal memory cell includes a write transistor (e.g., the write transistor 410 of FIG. 4) and a read transistor (e.g., the read transistor 420 of FIG. 4). As noted above, in a training mode 610, the universal memory (and the universal memory cells) is configured to operate in a DRAM mode or DRAM-like mode; in an inference mode 620, the universal memory (and the universal memory cells) is configured to operate in an NVM mode or NVM-like mode.

As shown in FIG. 6, the training mode 610 includes a weight changing procedure 612, a weight retention procedure 614, and a read-operation procedure 616. The weight changing procedure 612 is used to change weight $w_i$ (e.g., conductance $G_i$ in FIG. 2 or $G_{ij}$ in FIG. 3A). The weight retention procedure 614 is used to temporarily keep the weight $w_i$. The read-operation procedure 616 is used to read the weight $w_i$ and perform a product operation at the same time (e.g., MAC operation). In the training mode 610, the weight changing procedure 612, the weight retention procedure 614, and the read-operation procedure 616 can be executed repeatedly to optimize the AI model by continuously adjusting the weight $w_i$.

As shown in FIG. 6, the inference mode 620 includes a weight setting procedure 622, a weight retention procedure 624, and a read-operation procedure 626. The weight setting procedure 622 is used to set a fixed weight $w_i$ that is based on the training mode 610. The weight retention procedure 624 is used to keep the weight $w_i$. The read-operation procedure 626 is used to read the weight $w_i$ and perform a product operation (e.g., MAC operation) at the same time. In the inference mode 620, the weight $w_i$ is fixed and unchanged frequently.

In the following, operations of the write transistor and the read transistor of the universal memory cell of the universal memory in the training mode 610 (or DRAM mode) are described with respect to FIGS. 7A-7B, respectively. For illustration purposes, the universal memory, the universal memory cell, the write transistor, and the read transistor are described with respect to the universal memory 500, the universal memory cell 400, the write transistor 410, and the read transistor 420, respectively.

FIG. 7A shows a characteristic curve diagram 700 of the write transistor 410 in the training mode 610 or the DRAM mode. As shown in FIG. 7A, when a lower voltage $V_G = V_{WWL}$ is applied to the gate terminal 412 of the write transistor 410, the write transistor 410 can be turned off, e.g., during the weight retention procedure 614 and the read-operation procedure 616. When a higher gate voltage $V_G = V_{WWL}$ is applied to the gate terminal 412 of the write transistor, the write transistor 410 can be turned on, e.g., during the weight changing procedure 612, and a voltage can be applied to the first terminal 414 of the write transistor 410 to charge or discharge the storage node SN 402 coupled between the second terminal 416 of the write transistor 410 and the gate terminal 422 of the read transistor 420.

FIG. 7B shows a characteristic curve diagram 710 of the read transistor 420 in the training mode 610 or the DRAM mode. In the training mode 610, the charge trap layer 423 of the read transistor 420 remains unchanged, so the threshold voltage Vt of the read transistor 420 remains unchanged. When the gate terminal 422 of the read transistor 420 has a higher storage potential $V_{SN}$ that is higher than the threshold voltage Vt, the read transistor 420 can be turned on. When the gate terminal 422 of the read transistor 420 has a lower storage potential $V_{SN}$ that is lower than the threshold voltage Vt, the read transistor 420 can be turned off.

In the training mode 610, a high voltage signal (e.g., $V_{RBL}$) can be applied at the first terminal 424 of the read transistor 420 and a low voltage (e.g., $V_{ss}$) or a ground (e.g., 0) can be applied at the second terminal 426 of the read transistor 420. When the read transistor 420 is turned on, a logic state of data stored in the storage node 402 can be read out as bit "1". When the read transistor 420 is turned off, a logic state of the date stored in the storage node 402 can be read out as bit "0". Thus, in the training mode 610, the storage node 402 can be immediately charged or discharged to a higher storage potential or a lower storage potential, which further determines a logic state of readout data that can be used as a weight value of the universal memory cell 400. Moreover, the charge trap layer 423 of the read transistor 420 remains unchanged. Thus, the universal memory cell 400 can have high endurance (e.g., almost unlimited endurance), which is suitable for training of an AI model.

Operation of the universal memory cell 400 in the training mode 610 is described with further details below, with respect to weight w; of "0" and "1". In the training mode 610, the weight Wi is stored in the storage node SN 402 between the write transistor 410 and the read transistor 420.

When the universal memory cell 400 is going to be written the weight w; of "0" during the weight changing procedure 612 of the training mode 610, the write word line WWL is applied with a higher voltage $V_{WWL}$ (e.g., 3V) to turn on the write transistor 410, and the write bit line WBL is applied with a lower bias voltage $V_{WBL0}$ (e.g., 0V). Since the write transistor 410 is turned on, the voltage $V_{WBL}$ input by the write bit line WBL can be input to the storage node SN 402, so that the storage node SN 402 has a storage potential $V_{SN0}$ (e.g., 0V) lower than the threshold voltage Vt of the read transistor 420. The storage potential $V_{SN0}$ of the storage node SN can represent the weight w; of "0" of the universal memory cell 400.

During the weight retention procedure 614 of the training mode 610, the memory cell 400 intends to temporarily keep the weight w; during the training mode 610, a lower voltage $V_{WWL}$ (e.g., 0V) is applied to the write word line WWL to turn off the write transistor 410. Since the write transistor 410 is turned off, the storage potential $V_{SN0}$ of the storage node SN 402 remains unchanged.

During the read-operation procedure 616 of the training mode 610, when the weight w; of the universal memory cell 400 is going to be read and then multiplied, the write word line WWL is applied with a lower voltage $V_{WWL}$ (e.g., 0V) to turn off the write transistor 410, and the read bit line RBL is applied with an input voltage signal Vi (e.g., 0.8V). Since the storage potential $V_{SN}$ corresponding to weight w; of "0" is lower than the threshold voltage Vt of the read transistor 420, the read transistor 420 is turned off, and no read current Ii is generated on the read bit line RBL. The amount of the read current Ii (e.g., 0) is equivalent to the product of the input signal Vi and the weight $w_i$ of "0".

When the universal memory cell 400 is going to be written the weight w; of " 1" during the weight changing procedure 612 of the training mode 610, the write word line WWL is applied with a higher voltage $V_{WWL}$ (e.g., 3V) to turn on the write transistor 410, and the write bit line WBL is applied with a high voltage $V_{WBL}$ (e.g., 1V). Since the write transistor 410 has been turned on, the voltage $V_{WBL}$ input by the write bit line WBL can be input to the storage node SN 402, so that the storage node SN 402 has a storage potential $V_{SN1}$ (e.g., 1V) higher than the threshold voltage Vt of the read transistor 420. The storage potential $V_{SN1}$ of the storage node SN 402 can represent the weight w; of " 1" of the universal memory cell 400. As mentioned above, in the weight changing procedure 612 of the training mode 610, when the weight w; is changed, the threshold voltage Vt of the read transistor 420 is unchanged.

During the weight retention procedure 614 of the training mode 610, the memory cell 400 intends to temporarily keep the weight Wi during the training mode 610, a lower voltage $V_{WWL}$ (e.g., 0V) is applied to the write word line WWL to turn off the write transistor 410. Since the write transistor 410 is turned off, the storage potential $V_{SN1}$ of the storage node SN 402 remains unchanged.

During the read-operation procedure 616 of the training mode 610, when the weight Wi of the universal memory cell 400 is going to be read and then multiplied, the write word line WWL is applied with a lower voltage $V_{WWL}$ (e.g., 0V) to turn off the write transistor 410, and the read bit line RBL is applied with an input voltage signal Vi (e.g., 0.8V). Since the storage potential $V_{SN}$ corresponding to weight w; of "1" is higher than the threshold voltage Vt of the read transistor 420, the read transistor 420 is turned on, and a read current Ii is generated on the read bit line RBL. The amount of the read current Ii (e.g., 0) is equivalent to the product of the input signal Vi and the weight $w_i$ of "1".

The above-mentioned operation of the universal memory cell 400 in the training mode 610 or DRAM mode can be organized in the following Table I. Note that Table I only shows an example of values, and is not intended to limit the present disclosure.

Table I Values for DRAM-mode operation

|  | Write "0" | Write "1" | Retention | Read |
|---|---|---|---|---|
| $V_{WWL}$ | 3 V | 3 V | 0 V | 0 V |
| $V_{WBL}$ | 0 V | 1 V | Don't care | 0 V |
| $V_{RWL}$ | 0 V | 0 V | 0 V | 0 V |
| $V_{RBL}$ | 0 V | 0 V | 0 V | 0.8 V |

In the following, operations of the write transistor and the read transistor of the universal memory cell of the universal memory in the inference mode 620 (or NVM mode) are described with respect to FIGS. 8A-8B, respectively. For illustration purposes, the universal memory, the universal memory cell, the write transistor, and the read transistor are described with respect to the universal memory 500, the universal memory cell 400, the write transistor 410, and the read transistor 420, respectively.

In the inference mode 620 or NVM mode, a high voltage (e.g., +FN/-FN) can be applied on the gate terminal 422 of the read transistor 420 to charge or discharge the charge trap layer 423 of the read transistor 420, thereby changing the threshold voltage Vt of the read transistor 420. The threshold voltage Vt can be fixed, e.g., for long retention, to set a specific weight value for the universal memory cell 400, which can be applied in the inference mode 620 for the AI model. The weight value can be reset by changing the threshold voltage Vt by the high voltage (e.g., +FN/- FN) applied on the gate terminal 422 of the read transistor 420, e.g., based on a value of the high voltage and a time period for applying the high voltage.

FIG. 8A shows a characteristic curve diagram 800 of the write transistor 410 in the inference mode 620 or the NVM mode. As shown in FIG. 8A, when a lower voltage $V_G = V_{WWL}$ is applied to the gate terminal 412 of the write transistor 410, the write transistor 410 can be turned off. When a higher gate voltage $V_G = V_{WWL}$ is applied to the gate terminal 412 of the write transistor, the write transistor 410 can be turned on. During the weight setting procedure 622 of the inference mode 620, an FN high voltage (e.g., +FN/-FN such as +20V/-20V) is applied to the first terminal 414 of the write transistor 410 such that the storage potential at the storage node SN 402 can be charged or discharged to correspond to (e.g., be identical to) the high voltage (e.g., +FN/-FN). The voltage at the gate terminal 422 of the read transistor 420 is identical to the storage potential $V_{SN}$ at the storage node SN 402. Thus, the FN high voltage can change the threshold voltage Vt of the read transistor 420. During the read-operation procedure 626 of the inference mode 620, a read voltage Vread (e.g., 0.8V) is applied to the first terminal 414 of the write transistor 410, which can be used as an input signal for the universal memory cell 400, e.g., as described with further details in FIG. 10.

FIG. 8B is a diagram 810 showing a series of characteristic curves of the read transistor 420 in the inference mode 620 or the NVM mode. Each characteristic curve corresponds to a threshold voltage Vt of the read transistor 420, e.g., the characteristic curve shown in the diagram 710 of the read transistor 420. As noted above, the threshold voltage Vt can be set by the high voltage (e.g., +FN/-FN) applied at the write bit line. A value of the threshold voltage Vt can be based on the amount of charges in the charge trap layer 423 of the read transistor 420 that is based on a value of the high voltage and a time period for applying the high voltage. Thus, the value of the threshold voltage Vt can be tunable, e.g., between a lowest threshold voltage Vtmin and a highest threshold voltage Vtmax as illustrated in FIG. 8B.

After the threshold voltage Vt is set during the weight setting procedure 622, a read voltage Vread (e.g., 0.8V) is applied to the first terminal 414 of the write transistor 410, which can charge the storage node SN 402 to a high storage potential $V_{SN}$. When the storage potential $V_{SN}$ at the gate terminal 422 of the read transistor 420 is higher than the set threshold voltage Vt of the read transistor 420, the read transistor 420 can be turned on, and a supply voltage Vdd applied at the first terminal 424 of the read transistor 420 can generate a higher current Ii, corresponding to data "1". When the storage potential $V_{SN}$ at the gate terminal 422 is lower than the set threshold voltage Vt, the read transistor 420 can be turned off, corresponding to data "0". The read voltage Vread applied at the write bit line WBL can be between the lowest threshold voltage Vtmin and the highest threshold voltage Vtmax. Thus, in the inference mode 620, the weight w; of the universal memory cell 400 is represented by the set threshold voltage Vt of the read transistor 420.

Operation of the universal memory cell 400 in the inference mode 620 is described with further details below, with respect to weight Wi of "0" and "1". The read transistor 420 includes a charge trap layer 423 that can be charged or discharged to adjust the threshold voltage Vt of the read transistor 420.

When the universal memory cell 400 is going to be written the weight w; of "0" during the weight setting procedure 622 of the inference mode 620, the write word line WWL is applied with voltage $V_{ON}$ (e.g., 1 V) higher than a threshold voltage of the write transistor 410 to turn on the write transistor 410, and the write bit line WBL is applied with a positive high FN voltage (e.g., +FN). Since the write transistor 410 is turned on, the positive high FN voltage input by the write bit line WBL can be input to the storage node SN 402, so that the storage node SN 402 has a high storage potential $V_{SN0}$ (e.g., +FN), which can charge the charge trap layer 423 of the read transistor 420 to change the threshold voltage Vt of the read transistor 420, e.g., increased to a higher Vt. The higher Vt of the read transistor 420 can represent the weight w; of "0" of the universal memory cell 400.

During the weight retention procedure 624 of the inference mode 620, the memory cell 400 intends to fix the weight w; during the inference mode 620, a lower voltage $V_{WWL}$ (e.g., 0V) is applied to the write word line WWL to turn off the write transistor 410.

During the read-operation procedure 626 of the inference mode 620, when the weight w; of the universal memory cell 400 is going to be read and then multiplied, the write word line WWL is applied with voltage $V_{on}$ (e.g., 1V) higher than the threshold voltage of the write transistor 410 to turn on the write transistor 410, and the read bit line RBL is applied with an input voltage signal Vi (e.g., $V_{DD}$). The write bit line WBL is applied with a read voltage $V_{read}$ (e.g., 1V). As the read transistor 420 is set to have a higher Vt, that can be higher than the read voltage Vread, the read transistor 420 is turned off, and no read current Ii is generated on the read bit line RBL. The amount of the read current Ii (e.g., 0) is equivalent to the product of the input signal Vi and the weight w; of "0".

When the universal memory cell 400 is going to be written the weight w; of "1" during the weight setting procedure 622 of the inference mode 620, the write word line WWL is applied with voltage Von higher than the threshold voltage of the write transistor 410 to turn on the write transistor 410, and the write bit line WBL is applied with a negative high FN voltage (e.g., -FN). Since the write transistor 410 has been turned on, the negative high FN voltage input by the write bit line WBL can be input to the storage node SN 402, so that the storage node SN 402 has a negative high storage potential $V_{SN1}$ (e.g., -FN), which can discharge the charge trap layer 423 of the read transistor 420 to change the threshold voltage Vt of the read transistor 420, e.g., decreased to a lower Vt. The lower Vt of the read transistor 420 can represent the weight w; of " 1" of the universal memory cell 400.

During the weight retention procedure 624 of the inference mode 620, the memory cell 400 intends to fix the weight w; during the inference mode 620, a lower voltage $V_{WWL}$ (e.g., 0V) is applied to the write word line WWL to turn off the write transistor 410.

During the read-operation procedure 626 of the inference mode 620, when the weight w; of the universal memory cell 400 is going to be read and then multiplied, the write word line WWL is applied with voltage $V_{on}$ (e.g., 1V) higher than the threshold voltage of the write transistor 410 to turn on the write transistor 410, and the read bit line RBL is applied with an input voltage signal Vi (e.g., $V_{DD}$). The write bit line WBL is applied with a read voltage $V_{read}$ (e.g., 1V). As the read transistor 420 is set to have a lower Vt, that can be lower than the read voltage $V_{read}$, the read transistor 420 is turned on, and a read current Ii is generated on the read bit line RBL. The amount of the read current Ii is equivalent to the product of the input signal Vi and the weight w; of " 1".

The above-mentioned operation of the universal memory cell 400 in the inference mode 620 or NVM mode can be organized in the following Table II. Note that Table II only shows an example of values, and is not intended to limit the present disclosure. Note that Vread applied at the write bit line is between the minimum threshold voltage Vtmin and the maximum threshold voltage Vtmax of the read transistor 420.

Table II Values for NVM-mode operation

|  | Write "0" | Write "1" | Retention | Read |
|---|---|---|---|---|
| $V_{WWL}$ | Von | Von | 0 V | Von |
| $V_{WBL}$ | +FN | -FN | don't care | $V_{read}$ |
| $V_{RWL}$ | 0 V | 0 V | 0 V | 0 V |
| $V_{RBL}$ | 0 V | 0 V | 0 V | $V_{DD}$ |

The universal memory 500 can be applied to realize one or more operations of the AI model, e.g., multiply-accumulate (MAC) operation. The MAC operation is based on Ohmic's and Kirchoff's law. As shown in FIG. 5B, in the inference mode 620, a series of input voltages V1, V2, ..., Vn are applied on the corresponding read bit lines RBL1, RBL2, ..., RBLn, respectively. As noted above, the weight w; for each universal memory cell 400 is represented by the threshold voltage Vt of the read transistor 420 of the universal memory cell 400. The amount of the read current Ii (e.g., 0 or 1) from each universal memory cell 400 is equivalent to the product of the input signal Vi and the weight w; (e.g., 0 or 1). Accordingly, for each read word line 522, a total current I received by the SA 502 can be calculated based on the above equation (1): $I = \sum_{i=1}^{n}(w_i \cdot x_i) = \sum_{i=1}^{n}(G_i \cdot V_i)$, where Gi represents conductance of the read transistor 420, corresponding to the threshold voltage Vt of the read transistor 420 or the weight w;.

The above-mentioned weight w; is illustrated by taking the two-bit values of "0" and "1" as an example. In some other implementations, the weight w; may also be an analog value. As discussed with further detailed below, the read transistor 420 can be operated in a triode region or a saturation region. The universal memory cell 400 can be operated with analog weight and binary (1 or 0) input signals, e.g., in the saturation region, or with analog weight and analog input signals, e.g., in the triode region.

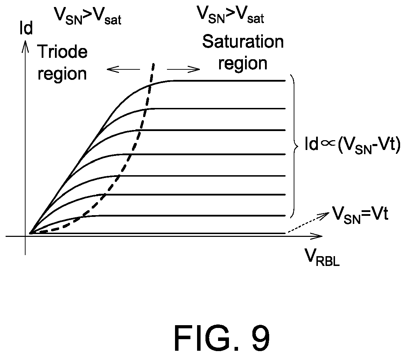

FIG. 9 illustrates a diagram 900 showing a relationship between a current and a voltage on the read bit line RBL. The current-voltage curves CVi correspond to different gate-overdrive voltages Vd. A gate-overdrive voltage Vd is a difference between the storage potential $V_{SN}$ and the threshold voltage Vt of the read transistor 420. Corresponding to different threshold voltages Vt, different degrees of gate-overdrive voltage Vd can be formed. The upper curve CVi in FIG. 9 corresponds to a higher gate-overdrive voltage Vd. The current formed on the read bit line RBL is positively correlated with the gate-overdrive voltage Vd, e.g., $I_d \propto (V_{SN} - V_t)$. That is, when $V_{SN}$ is a predetermined voltage and remains constant, the current formed on the read bit line RBL is negatively correlated with the threshold voltage Vt. Therefore, various levels of the threshold voltage Vt of the read transistor 420 can cause the weight w; to have different levels of analog values.

The current-voltage curves CVi can be divided based on a relationship between the voltage (e.g., $V_{SN}$) at the gate terminal 422 of the read transistor 420 and a saturation voltage Vsat. When $V_{SN}$ > Vsat, the read transistor 420 is operated within a saturation region, and the universal memory cell 400 can be operated with analog weight w; and binary (1 or 0) input signals, e.g., as described in FIG. 10A. When $V_{SN}$ < Vsat, the read transistor 420 is operated within a triode region, and the universal memory cell 400 can be operated with analog weight and analog input signals, e.g., as described in FIG. 10B.

FIG. 10A shows an example operation in the saturation region of the read transistor 420, e.g., as shown in the shadow area, where $V_{SN}$ > Vsat. The threshold voltage Vt of the read transistor 420 can be analog, and voltage $V_{RBL}$ is an input signal applied at the read bit line, which can have a bit value "1" or "0". When voltage $V_{RBL}$ corresponds to bit "0", e.g., 0 V, no current is formed. When voltage $V_{RBL}$ corresponds to bit "1", a current is formed and is proportional to $(V_{SN} - V_t)$. To guarantee input "1", the voltage $V_{RBL}$ is no less than the maximum value of $(V_{SN} - V_t)$. As $V_{SN}$ is identical to $V_{WBL}$ applied at the write bit line, which can be kept constant, the maximum value of $(V_{SN} - V_t)$ is equivalent to $(V_{SN}-Vtmin)$, where Vtmin is a minimum threshold voltage of the read transistor 420 in the saturation region, e.g., as shown in FIG. 10A.

The operation of the universal memory cell 400 in the inference mode 620 or NVM mode and in the saturation region of the read transistor 420 can be organized in the following Table III. Note that Table III only shows an example of values, and is not intended to limit the present disclosure.

Table III Values for NVM-mode operation in Saturation Region

|  | Vt rising | | Vt falling | | Retention | Read |
|---|---|---|---|---|---|---|
| $V_{WWL}$ | Von | | Von | | 0V | Von |
| $V_{WBL}$ | +FN | 0V | -FN | 0V | 0V | <=$V_{DD}$ |
| $V_{RWL}$ | 0V | -FN | 0 V | +FN | 0V | 0V |
| $V_{RBL}$ | 0V | -FN | 0 V | +FN | 0V | $V_{RBL}>V_{dd}-V_{tmin}$ |

As Table III shows, during the weight setting procedure 622 of the inference mode 620, for Vt rising, the write transistor 410 is turned on with voltage Von higher than the threshold voltage of the write transistor 410 is applied at the write word line WWL. In some cases, a positive high FN voltage (e.g., +FN) is applied on the write bit line, $V_{RWL}$ and $V_{RBL}$ applied at the read word line RWL and read bit line RBL are both identical to 0 V, and thus the storage potential at the SN 402 is increased to the positive high FN voltage, which can charge the charge trap layer 423 of the read transistor 420 to increase the threshold voltage Vt of the read transistor 420. In some cases, a low voltage (e.g., 0) is applied on the write bit line ($V_{WBL}$=0V), $V_{RWL}$ and $V_{RBL}$ applied at the read word line RWL and read bit line RBL are both identical to -FN, and a voltage potential between the gate terminal 422 and the second terminal 426 is +FN, which can also charge the charge trap layer 423 of the read transistor 420 to increase the threshold voltage Vt of the read transistor 420.

Similarly, during the weight setting procedure 622 of the inference mode 620, for Vt falling, the write transistor 410 is turned on with voltage Von higher than the threshold voltage of the write transistor 410 is applied at the write word line WWL. In some cases, a negative high FN voltage (e.g., -FN) is applied on the write bit line, $V_{RWL}$ and $V_{RBL}$ applied at the read word line RWL and read bit line RBL are both identical to 0 V, and thus the storage potential at the SN 402 is decreased to negative high FN voltage (e.g., -FN), which can discharge the charge trap layer 423 of the read transistor 420 to decrease the threshold voltage Vt of the read transistor 420. In some cases, a low voltage (e.g., 0) is applied on the write bit line ($V_{WBL}$=0V), $V_{RWL}$ and $V_{RBL}$ applied at the read word line RWL and read bit line RBL are both identical to +FN, and a voltage potential between the first terminal 424 and the gate terminal 422 is +FN, which can also discharge the charge trap layer 423 of the read transistor 420 to decrease the threshold voltage Vt of the read transistor 420.

During the weight retention procedure 624 of the inference mode 620, $V_{WWL}$ = 0V to turn off the write transistor 410, $V_{WBL}$ can be any value, e.g., 0V. $V_{RWL}$ and $V_{RBL}$ can both be identical to 0V, and thus no current is formed, and the analog threshold voltage Vt of the read transistor 420 remains unchanged and can be fixed for long retention to determine a specific weight value of the universal memory cell 400.

During the read-operation procedure 626 of the inference mode 620, the write transistor 410 is turned on with voltage Von higher than the threshold voltage of the write transistor 410 is applied at the write word line WWL. A read voltage $V_{WBL}$ is applied at the write bit line WBL, which can be no greater than a supply voltage $V_{DD}$. The second terminal 426 of the read transistor 420 is coupled to the ground, e.g., 0 V, and the first terminal 424 of the read transistor 420 is applied with an input signal $V_{RBL}$ that is larger than $V_{dd}$-$V_{tmin}$ to guarantee that the read transistor 420 is operated in the saturation region.

The universal memory 500 can be applied to realize one or more operations of the AI model, e.g., multiply-accumulate (MAC) operation. The MAC operation is based on Ohmic's and Kirchoff's law. As shown in FIG. 5B, in the inference mode 620, a series of input voltages V1, V2, ..., Vn are applied on the corresponding read bit lines RBL1, RBL2, ..., RBLn, respectively. As noted above, the weight w; for each universal memory cell 400 is represented by the threshold voltage Vt of the read transistor 420 of the universal memory cell 400 that is analog. The amount of the read current Ii from each universal memory cell 400 is equivalent to the product of the input signal Vi (e.g., 0 or 1) and the analog weight w;. Accordingly, for each read word line 522, a total current I received by the SA 502 can be calculated based on the above equation (1): $I = \sum_{i=1}^{n}(w_i \cdot x_i) = \sum_{i=1}^{n}((V_{SN} - V_t) * V_i)$ , where $V_{SN}$ is kept constant and ($V_{SN}$-$V_t$) corresponds to the analog weight w; of the universal memory cell 400.

FIG. 10B shows an example operation in the triode region of the read transistor 420, e.g., as shown in the shadow area, where $V_{SN}$ < Vsat. The threshold voltage Vt of the read transistor 420 can be analog, and various Vt can serve as analog weights. Voltage $V_{RBL}$ is an input signal applied at the read bit line, and meets a requirement to make sure the read transistor 420 is in the triode region. Thus, $V_{RBL}$ can also be in an analog input range, 0<=$V_{RBL}$<=$V_{SN}$-$V_{tmax}$, e.g., as illustrated in FIG. 10B.

The operation of the universal memory cell 400 in the inference mode 620 or NVM mode and in the triode region of the read transistor 420 can be organized in the following Table IV. Note that Table IV only shows an example of values, and is not intended to limit the present disclosure.

Table IV Values for NVM-mode operation in Triode Region

| | Vt rising | | Vt falling | | Retention | Read |
|---|---|---|---|---|---|---|
| $V_{WWL}$ | Von | | Von | | 0V | Von |
| $V_{WBL}$ | +FN | 0V | -FN | 0V | 0V | <=$V_{DD}$ |
| $V_{RWL}$ | 0V | -FN | 0 V | +FN | 0V | 0V |
| $V_{RBL}$ | 0V | -FN | 0 V | +FN | 0V | $V_{RBL}$<$V_{dd}$-$V_{tmax}$ |

As Table IV shows, during the weight setting procedure 622 of the inference mode 620, for Vt rising, the write transistor 410 is turned on with voltage Von higher than the threshold voltage of the write transistor 410 is applied at the write word line WWL. In some cases, a positive high FN voltage (e.g., +FN) is applied on the write bit line, $V_{RWL}$ and $V_{RBL}$ applied at the read word line RWL and read bit line RBL are both identical to 0 V, and thus the storage potential at the SN 402 is increased to the positive high FN voltage, which can charge the charge trap layer 423 of the read transistor 420 to increase the threshold voltage Vt of the read transistor 420. In some cases, a low voltage (e.g., 0) is applied on the write bit line ($V_{WBL}$=0V), $V_{RWL}$ and $V_{RBL}$ applied at the read word line RWL and read bit line RBL are both identical to -FN, and a voltage potential between the gate terminal 422 and the second terminal 426 is +FN, which can also charge the charge trap layer 423 of the read transistor 420 to increase the threshold voltage Vt of the read transistor 420.

Similarly, during the weight setting procedure 622 of the inference mode 620, for Vt falling, the write transistor 410 is turned on with voltage Von higher than the threshold voltage of the write transistor 410 is applied at the write word line WWL. In some cases, a negative high FN voltage (e.g., -FN) is applied on the write bit line, $V_{RWL}$ and $V_{RBL}$ applied at the read word line RWL and read bit line RBL are both identical to 0 V, and thus the storage potential at the SN 402 is decreased to negative high FN voltage (e.g., -FN), which can discharge the charge trap layer 423 of the read transistor 420 to decrease the threshold voltage Vt of the read transistor 420. In some cases, a low voltage (e.g., 0) is applied on the write bit line ($V_{WBL}$=0V), $V_{RWL}$ and $V_{RBL}$ applied at the read word line RWL and read bit line RBL are both identical to +FN, and a voltage potential between the first terminal 424 and the gate terminal 422 is +FN, which can also discharge the charge trap layer 423 of the read transistor 420 to decrease the threshold voltage Vt of the read transistor 420.

During the weight retention procedure 624 of the inference mode 620, $V_{WWL}$ = 0V to turn off the write transistor 410, $V_{WBL}$ can be any value, e.g., 0V. $V_{RWL}$ and $V_{RBL}$ can both be identical to 0V, and thus no current is formed, and the analog threshold voltage Vt of the read transistor 420 remains unchanged and can be fixed for long retention to determine a specific weight value of the universal memory cell 400.

During the read-operation procedure 626 of the inference mode 620, the write transistor 410 is turned on with voltage Von higher than the threshold voltage of the write transistor 410 is applied at the write word line WWL. A read voltage $V_{WBL}$ is applied at the write bit line WBL, which can be no greater than a supply voltage $V_{DD}$. The second terminal 426 of the read transistor 420 is coupled to the ground, e.g., 0 V, and the first terminal 424 of the read transistor 420 is applied with an input signal $V_{RBL}$ that is smaller than $V_{dd}$-$V_{tmax}$ to guarantee that the read transistor 420 is operated in the triode region.

The universal memory 500 can be applied to realize one or more operations of the AI model, e.g., multiply-accumulate (MAC) operation. The MAC operation is based on Ohmic's and Kirchoff's law. As shown in FIG. 5B, in the inference mode 620, a series of input voltages V1, V2, ..., Vn are applied on the corresponding read bit lines RBL1, RBL2, ..., RBLn, respectively. As noted above, the weight w; for each universal memory cell 400 is represented by the threshold voltage Vt of the read transistor 420 of the universal memory cell 400 that is analog. The amount of the read current Ii from each universal memory cell 400 is equivalent to the product of the analog input signal $V_i$ (e.g., in a range of 0 and $V_{dd}$-$V_{tmax}$) and the analog weight w;. Accordingly, for each read word line 522, a total current I received by the SA 502 can be calculated based on the above equation (1):

$$I = \sum_{i=1}^{n}(w_i \cdot x_i) = \sum_{i=1}^{n}((V_{SN} - V_t) \cdot V_i)$$

, where $V_{SN}$ is kept constant and ($V_{SN}$ - $V_t$) corresponds to the analog weight w; of the universal memory cell 400, and $V_i$ is an analog input signal.

The disclosed and other examples can be implemented as one or more computer program products, for example, one or more modules of computer program instructions encoded on a computer readable medium for execution by, or to control the operation of, data processing apparatus. The computer readable medium can be a machine-readable storage device, a machine-readable storage substrate, a memory device, or a combination of one or more them. The term "data processing apparatus" encompasses all apparatus, devices, and machines for processing data, including by way of example a programmable processor, a computer, or multiple processors or computers. The apparatus can include, in addition to hardware, code that creates an execution environment for the computer program in question, e.g., code that constitutes processor firmware, a protocol stack, a database management system, an operating system, or a combination of one or more of them.

A system may encompass all apparatus, devices, and machines for processing data, including by way of example a programmable processor, a computer, or multiple processors or computers. A system can include, in addition to hardware, code that creates an execution environment for the computer program in question, e.g., code that constitutes processor firmware, a protocol stack, a database management system, an operating system, or a combination of one or more of them.

A computer program (also known as a program, software, software application, script, or code) can be written in any form of programming language, including compiled or interpreted languages, and it can be deployed in any form, including as a standalone program or as a module, component, subroutine, or other unit suitable for use in a computing environment. A computer program does not necessarily correspond to a file in a file system. A program can be stored in a portion of a file that holds other programs or data (e.g., one or more scripts stored in a markup language document), in a single file dedicated to the program in question, or in multiple coordinated files (e.g., files that store one or more modules, sub programs, or portions of code). A computer program can be deployed for execution on one computer or on multiple computers that are located at one site or distributed across multiple sites and interconnected by a communications network.

The processes and logic flows described in this document can be performed by one or more programmable processors executing one or more computer programs to perform the functions described herein. The processes and logic flows can also be performed by, and apparatus can also be implemented as, special purpose logic circuitry, e.g., an FPGA (field programmable gate array) or an ASIC (application specific integrated circuit).

Processors suitable for the execution of a computer program include, by way of example, both general and special purpose microprocessors, and any one or more processors of any kind of digital computer. Generally, a processor will receive instructions and data from a read only memory or a random access memory or both. The essential elements of a computer can include a processor for performing instructions and one or more memory devices for storing instructions and data. Generally, a computer can also include, or be operatively coupled to receive data from or transfer data to, or both, one or more mass storage devices for storing data, e.g., magnetic, magneto optical disks, or optical disks. However, a computer need not have such devices. Computer readable media suitable for storing computer program instructions and data can include all forms of nonvolatile memory, media and memory devices, including by way of example semiconductor memory devices, e.g., EPROM, EEPROM, and flash memory devices, and magnetic disks. The processor and the memory can be supplemented by, or incorporated in, special purpose logic circuitry.

While this document may describe many specifics, these should not be construed as limitations on the scope of an invention that is claimed or of what may be claimed, but rather as descriptions of features specific to particular embodiments. Certain features that are described in this document in the context of separate embodiments can also be implemented in combination in a single embodiment. Conversely, various features that are described in the context of a single embodiment can also be implemented in multiple embodiments separately or in any suitable sub-combination. Moreover, although features may be described above as acting in certain combinations and even initially claimed as such, one or more features from a claimed combination in some cases can be excised from the combination, and the claimed combination may be directed to a sub-combination or a variation of a sub-combination. Similarly, while operations are depicted in the drawings in a particular order, this should not be understood as requiring that such operations be performed in the particular order shown or in sequential order, or that all illustrated operations be performed, to achieve desirable results.

Only a few examples and implementations are disclosed. Variations, modifications, and enhancements to the described examples and implementations and other implementations can be made based on what is disclosed.

**Claims**

1.  A semiconductor circuit, comprising:

    a first transistor (410); and
    a second transistor (420),
    wherein the first transistor (410) has a gate terminal (412) configured to receive a gate voltage to turn on or off the first transistor (410), a first terminal (414) configured to receive a write voltage, and a second terminal (416) coupled to a gate terminal (412) of the second transistor(420), and
    wherein the second transistor (420) comprises a charge trap layer (423) at the gate terminal (422) of the second transistor (420), the charge trap layer (423) being configured to:

    be unalterable when a first write voltage is applied at the first terminal (414) of the first transistor (410), and
    be alterable when a second write voltage is applied at the first terminal (414) of the first transistor (410) to change a threshold voltage of the second transistor (420), the second write voltage being greater than the first write voltage.

2.  The semiconductor circuit of claim 1, wherein the semiconductor circuit is configured to:

    operate in a first mode where a storage potential of a storage node (402) between the second terminal (416) of the first transistor (410) and the gate terminal (422) of the second transistor (420) is determined based on the first write voltage applied at the first terminal (414) of the first transistor (410) while the first transistor (410 )is turned on, the threshold voltage of the second transistor (420) remaining unchanged, the storage potential of the storage node (402) being repeatedly changeable based on the first write voltage, and
    operate in a second mode where the second transistor (420) is programmed or erased to have a particular threshold voltage based on the second write voltage applied at the first terminal (414) of the first transistor (410) while the first transistor (410) is turned on, the particular threshold voltage being tunable based on the second write voltage.

3.  The semiconductor circuit of claim 2, wherein the first mode comprises a training mode (610) of an artificial intelligence (AI) model or a dynamic random-access memory (DRAM)-like mode, and the second mode comprises an inference mode (620) of the AI model or a non-volatile memory (NVM)-like mode.

4.  The semiconductor circuit of claim 2 or 3, wherein the storage potential of the storage node (402) corresponds to an adjustable weight in the first mode, and the particular threshold voltage of the second transistor (420) corresponds to a fixed weight in the second mode.

5. The semiconductor circuit of claim 2 or 3, wherein the particular threshold voltage of the second transistor (420) corresponds to a binary weight "1" or "0" in the second mode.

6. The semiconductor circuit of claim 2 or 3, wherein the particular threshold voltage of the second transistor (420) corresponds to an analog weight in the second mode, and the particular threshold voltage is tunable between a minimum threshold voltage and a maximum threshold voltage.

7. The semiconductor circuit of claim 6, wherein the second transistor (420) is configured to be operated in a saturation region, and the storage potential of the storage node (402) in the second mode is greater than a saturation voltage associated with the second transistor (420), and
   wherein the second transistor (420) is configured to receive a binary input signal at the first terminal (424) of the second transistor (420), wherein the binary input signal represents "1" if the binary input signal has a voltage greater than a difference between the storage potential of the storage node (402) and the minimum threshold voltage and represents "0" if the binary input signal has a voltage identical to 0 V.

8. The semiconductor circuit of claim 6, wherein the second transistor (420) is configured to be operated in a triode region, and the storage potential of the storage node (402) in the second mode is smaller than a saturation voltage associated with the second transistor (420), and
   wherein the second transistor (420) is configured to receive an analog input signal at the first terminal (424) of the second transistor (420), wherein the analog input signal has a voltage in a range between 0 V and a voltage difference between the storage potential of the storage node (402) and the maximum threshold voltage.

9. The semiconductor circuit of anyone of the claims 1 to 8, wherein the second transistor (420) comprises a silicon-oxide-nitride-oxide-silicon (SONOS) transistor, and
   wherein the first transistor (410) comprises a metal-oxide-semiconductor (MOS) transistor or an SONOS transistor.

10. A semiconductor device, comprising:

    an array of memory cells (210, 220, 230, 240);
    one or more write word lines (WWLs);
    one or more write bit lines (WBLs);
    one or more read word lines (RWLs); and
    one or more read bit lines (RBLs),
    wherein each memory cell of the array of memory cells (210, 220, 230, 240) comprises the semiconductor circuit of any one of claims 1 to 9,
    wherein the gate terminal (412) of the first transistor (410) is coupled to a corresponding write word line (WWL), a first terminal (414) of the first transistor (410) is coupled to a corresponding write bit line (WBL), and a second terminal (416) of the first transistor (410) is coupled to a gate terminal (422) of the second transistor (420), and
    wherein the first terminal (424) of the second transistor (420) is coupled to a corresponding read bit line (RBL) and a second terminal (426) of the second transistor (420) is coupled to a corresponding read word line (RWL), and
    wherein the charge trap layer (423) is configured to:
    be alterable when the second write voltage through the corresponding write bit line (WBL) is applied at the first terminal (414) of the first transistor (410) to change the threshold voltage of the second transistor (420).

11. The semiconductor device of claim 10, wherein the array of memory cells (210, 220, 230, 240) is arranged in an area defined by a first direction and a second direction perpendicular to the first direction, and wherein:

    each of the one or more write word lines (WWL) is coupled to gate terminals (412) of first transistors (410) of first memory cells (210, 220, 230, 240) along the first direction,
    each of the one or more write bit lines (WBL) is coupled to first terminals (414) of first transistors (410) of second memory cells (210, 220, 230, 240) along the second direction,
    each of the one or more read bit lines (RBL) is coupled to first terminals (424) of read transistors (420) of third memory cells (210, 220, 230, 240) along the first direction, and
    each of the one or more read word lines (RWL) is coupled to second terminals (426) of second transistors (420) of fourth memory cells (210, 220, 230, 240) along the second direction.

12. The semiconductor device of claim 10 or 11, wherein the second transistor (420) is configured to be operated in a saturation region, and the storage potential of the storage node (402) in the inference mode (620) is greater than a saturation voltage associated with the second transistor (420), and

wherein the second transistor (420) is configured to receive a binary input signal through a corresponding read bit line (RBL) at the first terminal (424) of the second transistor (420), wherein the binary input signal represents "1" if the binary input signal has a voltage greater than a difference between the storage potential of the storage node (402) and the minimum threshold voltage and represents "0" if the binary input signal has a voltage identical to 0 V.

13. The semiconductor device of claim 10 or 11, wherein the second transistor (420) is configured to be operated in a triode region, and the storage potential of the storage node (402) in the inference mode (620) is smaller than a saturation voltage associated with the second transistor (420), and

wherein the second transistor (420) is configured to receive an analog input signal through a corresponding read bit line (RBL) at the first terminal (424) of the second transistor (420), wherein the analog input signal has a voltage in a range between 0 V and a voltage difference between the storage potential of the storage node (402) and the maximum threshold voltage.

14. The semiconductor device of anyone of the claims 10 to 13, wherein the semiconductor device is configured to perform a multiply-accumulate (MAC) operation using the array of memory cells (210, 220, 230, 240),

wherein the semiconductor device further comprises a sense amplifier (502) coupled to a corresponding read word line (RWL) that is coupled to second terminals (426) of second transistors (420) of corresponding memory cells (210, 220, 230, 240),

wherein the sense amplifier (502) is configured to receive a sum current I from the corresponding read word line (RWL), and

wherein the sum current *I* is identical to

$$ I = \sum_i (w_i * x_i) = \sum_i (G_i * V_i), $$

where $x_i$ represents an input signal received at memory cell *i* of the corresponding memory cells (210, 220, 230, 240), $w_i$ represents a weight of the memory cell *i*, $G_i$ represents a conductance of the read transistor of the memory cell *i*, and $V_i$ represents an input voltage through a corresponding read bit line (RBL) at the first terminal (424) of the second transistor (420) of the memory cell *i*.

15. An operation method of a universal memory for In-Memory Computing (IMC), the operation method comprising:

performing a training mode (610) of an artificial intelligence (AI) model in the universal memory (500),

wherein the universal memory (500) comprises at least one memory cell having a write transistor (410) and a read transistor (420),

wherein the write transistor (410) has a gate terminal (412) configured to receive a gate voltage to turn on or off the write transistor (410), a first terminal (414) configured to receive a write voltage, and a second terminal (416) coupled to a gate terminal (422) of the read transistor (420), and

wherein, during the training mode (610), a storage potential of a storage node (402) between the second terminal (416) of the write transistor (410) and the gate terminal (422) of the read transistor (420) is determined based on a first write voltage applied at the first terminal (414) of the write transistor (410) while the write transistor (410) is turned on by a gate voltage applied at the gate terminal (412) of the write transistor (410), a threshold voltage of the read transistor (420) remaining unchanged, the storage potential of the storage node (402) being repeatedly changeable based on the first write voltage; and

performing an inference mode (620) of the AI model in the universal memory (500), wherein, in the inference mode (620), the read transistor (420) is programmed or erased to have a particular threshold voltage based on a second write voltage applied at the first terminal (414) of the write transistor (410) while the write transistor (410) is turned on, the particular threshold voltage being tunable based on the second write voltage.

FIG. 1A

FIG. 1B

FIG. 2

FIG. 3A

FIG. 3B

400

WWL
(Write word line)

412

413

SN 402

RBL
(Read bit line)

424

WBL
(Write bit line)

414

416

422

Read transistor
420

Write transistor
410

426

Charge trap
layer 423

RWL
(Read word line)

# FIG. 4

FIG. 5A

FIG. 5B

EP 4 521 407 A1

Training mode 610

Weight changing
procedure 612

Weight retention
procedure 614

Read-operation
procedure 616

Inference mode 620

Weight setting
procedure 622

Weight retention
procedure 624

Read-operation
procedure 626

FIG. 6

700

DRAM Mode
Write Transistor

Id

Read/retention    Write    $V_G=V_{WWL}$

# FIG. 7A

710

DRAM Mode
Read Transistor

Id

$I_{read}(Data\ 1)$

Data=1

Isense

$I_{read}(Data\ 0)$    Data=0

Low $V_{SN}$    High $V_{SN}$    $V_G=V_{SN}$

# FIG. 7B

800

NVM Mode
Write Transistor

Id

$V_G=V_{WWL}$

Vt    Von

# FIG. 8A

810

NVM Mode
Read Transistor

Id

$I_{read}$(Data 1)

Isense

Vtmin    . . .    Vtmax

$V_G=V_{SN}=V_{WBL}$

Tunable Vt

# FIG. 8B

FIG. 9

**FIG. 10A**

**FIG. 10B**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/077397 A1 (KURITA TAKAHIRO [JP] ET AL) 28 March 2013 (2013-03-28) | 1,9-11, 14 | INV.<br>G11C11/404 |
| Y | * paragraphs [0027] - [0063]; figures 1-18 | 2-6 | G06N3/063 |
| A | * | 7,8,12, 13,15 | G11C11/54<br>G11C14/00<br>G11C16/04 |
| | - - - - - | | |
| Y | US 2023/162774 A1 (YOUNG BO-FENG [TW] ET AL) 25 May 2023 (2023-05-25) | 2-6 | |
| | * paragraphs [0018] - [0201]; figures 1-7 * | | |
| | - - - - - | | |

| TECHNICAL FIELDS SEARCHED (IPC) |
|---|
| G11C<br>G06N |

The present search report has been drawn up for all claims

| Place of search | Date of completion of the search | Examiner |
|---|---|---|
| The Hague | 23 September 2024 | Czarik, Damien |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 24 16 1180

This annex lists the patent family members relating to the patent documents cited in the above-mentioned European search report.
The members are as contained in the European Patent Office EDP file on
The European Patent Office is in no way liable for these particulars which are merely given for the purpose of information.

23-09-2024

| Patent document cited in search report | Publication date | Patent family member(s) | | Publication date |
|---|---|---|---|---|
| US 2013077397 A1 | 28-03-2013 | JP | 5677254 B2 | 25-02-2015 |
| | | JP | 2013073954 A | 22-04-2013 |
| | | KR | 20130033271 A | 03-04-2013 |
| | | TW | 201314870 A | 01-04-2013 |
| | | US | 2013077397 A1 | 28-03-2013 |
| US 2023162774 A1 | 25-05-2023 | CN | 113380291 A | 10-09-2021 |
| | | DE | 102021106058 A1 | 02-12-2021 |
| | | KR | 20210148891 A | 08-12-2021 |
| | | KR | 20240063101 A | 09-05-2024 |
| | | TW | 202145219 A | 01-12-2021 |
| | | US | 2023162774 A1 | 25-05-2023 |
| | | US | 2024096388 A1 | 21-03-2024 |

EPO FORM P0459

For more details about this annex : see Official Journal of the European Patent Office, No. 12/82